# EUROPEAN PATENT APPLICATION

(11) **EP 1 983 808 A1**
(43) Date of publication of application: **22.10.2008**
(21) Application number: 07007826.6
(22) Date of filing: 17.04.2007
(51) Int. Cl.: H05K 1/11, H05K 3/04, H05K 3/20, H05K 3/40

(54) **Method for manufacturing tape carrier for contact type IC card**

(71) Applicant: TIBC CORPORATION, Obu-shi Aichi-ken 474-8601 (JP)
(72) Inventor: Furuta, Tetsuya, Obu-shi Aichi-ken 474-8601 (JP); Ote, Manabu, Obu-shi Aichi-ken 474-8601 (JP); Kitano, Kouhei, Obu-shi Aichi-ken 474-8601 (JP)
(74) Representative: Geyer, Fehners & Partner

(57) **Abstract**

A method for manufacturing a tape carrier for a contact type IC card including a substrate. The method includes punching a conductive foil with a punching tool to obtain a pad group including a plurality of contact pads, and arranging the pad group on a substrate made of an insulative material. This reduces the processes, work, and cost for manufacturing a tape carrier in comparison to when performing lithography.

## Description

The present invention relates to a method for manufacturing a tape carrier for a contact type IC card.

Japanese Laid-Open Patent Publication No. 7-202380 describes a typical contact type IC card tape carrier. The tape carrier is used to form modules incorporated in contact type IC cards. The tape carrier includes a strip-shaped substrate (printed wiring board) and a plurality of contact pad groups formed on the surface of the substrate. Each contact pad group corresponds to one of the modules.

IC chip regions, in which IC chips are arranged, and a plurality of bonding holes, are provided on the substrate at portions corresponding to the contact pad groups. The substrate has a thickness of 100 µm and is made of glass epoxy.

Contact pads, which form each contact pad group, are made of, for example, copper, and adhered to the surface of the substrate with an adhesive. The formation of the contact pads on the surface of the substrate will now be described.

First, an adhesive is applied to the substrate, and copper foil is arranged on the substrate. Then, the adhesive is hardened and the copper foil is adhered to the substrate. Subsequently, a photoresist is applied to the copper foil to perform exposure, development, and etching. The resist is then removed to form the contact pads. Further, electroplating is performed to apply a plating layer of, for example, nickel or gold, to the surface of each contact pad.

The modules are punched out from the substrate, which includes the pad groups, along a punching line surrounding each pad group. In this manner, the modules are obtained from the tape carrier. After the punching, an IC chip is arranged in the IC chip region defined in each punched out portion of the substrate. Subsequently, wire bonding is performed to connect the IC chip to the contact pads on the punched out portion of the substrate. This completes the module. Then, the module is incorporated in an IC card. The IC card is inserted into an IC card reader. In this state, terminals of the reader come into contact with the contact pads of the module so that data is readable from the IC chip of the module.

As described above, photolithography technology is employed to form the contact pads on the surface of the substrate. However, this technology, which involves a number of processes, is complicated and increases costs.

It is an object of the present invention to provide a simple and inexpensive method for manufacturing a tape carrier for a contact type IC card.

One aspect of the present invention is a method for manufacturing a tape carrier for a contact type IC card. The method includes punching a conductive foil with a punching tool to obtain a pad group including a plurality of contact pads, and arranging the pad group on a substrate made of an insulative material.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a plan view showing an IC card according to a preferred embodiment of the present invention;
Fig. 2A is an enlarged plan view showing a module arranged in the IC card of Fig. 1;
Fig. 2B is a cross-sectional view taken along line 2B-2B in Fig. 2A;
Fig. 3 is a rear perspective view showing the module of Fig. 2A;
Fig. 4 is a cross-sectional view showing a substrate and a pad group in the module of Fig. 2A;
Fig. 5 is a plan view showing a tape carrier;
Figs. 6A and 6B are schematic diagrams showing a method for forming contact pads of the present invention on a substrate;
Figs. 7A and 7B are schematic diagrams showing another method for forming contact pads of the present invention on a substrate;
Figs. 8A and 8B are schematic diagrams showing a further method for forming contact pads of the present invention on a substrate;
Fig. 9 is a plan view showing a pad group in a modification of the preferred embodiment;
Fig. 10 is a cross-sectional view showing modules in another modification of the preferred embodiment; and
Figs. 11A and 11B are cross-sectional views showing modules in further modifications of the preferred embodiment.

A preferred embodiment of the present invention will now be discussed.

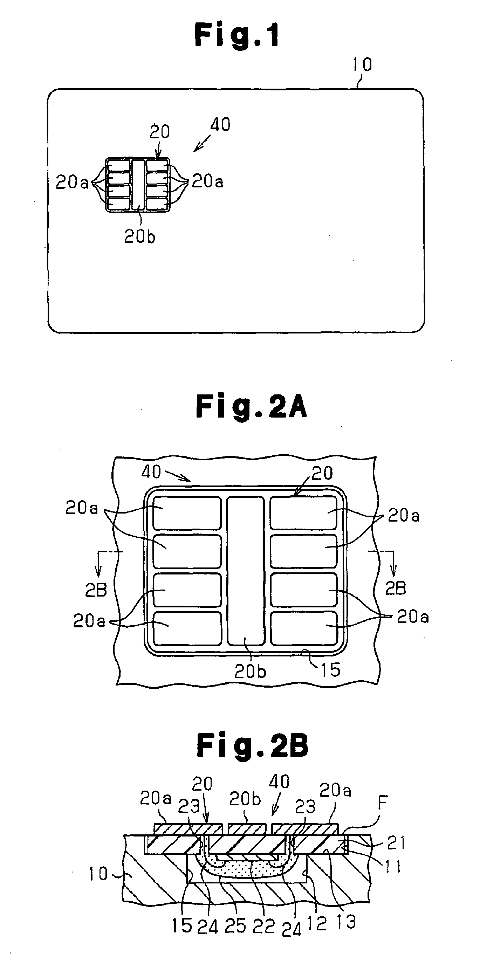

The structure of a contact type IC card will first be described with reference to Fig. 1. As shown in Fig. 1, the IC card includes a card body 10 and a module 40, which is arranged on the card body 10.

The card body 10 is made of, for example, a polyvinyl chloride resin, and has a surface in which patterns or characters are printed. The module 40 is adhered to the card body 10 with, for example, an adhesive.

Referring to Figs. 2A and 2B, the card body 10 includes a rectangular accommodation recess 15 for accommodating the module 40. The accommodation recess 15 includes a shallow hollow portion 11 and a deep hollow portion 12, which has a smaller side cross-section than the shallow hollow portion 11. A stepped portion 13 is defined between the shallow hollow portion 11 and the deep hollow portion 12. The module 40 is arranged in the accommodation recess 15 in a state fixed to the stepped portion with an adhesive or the like.

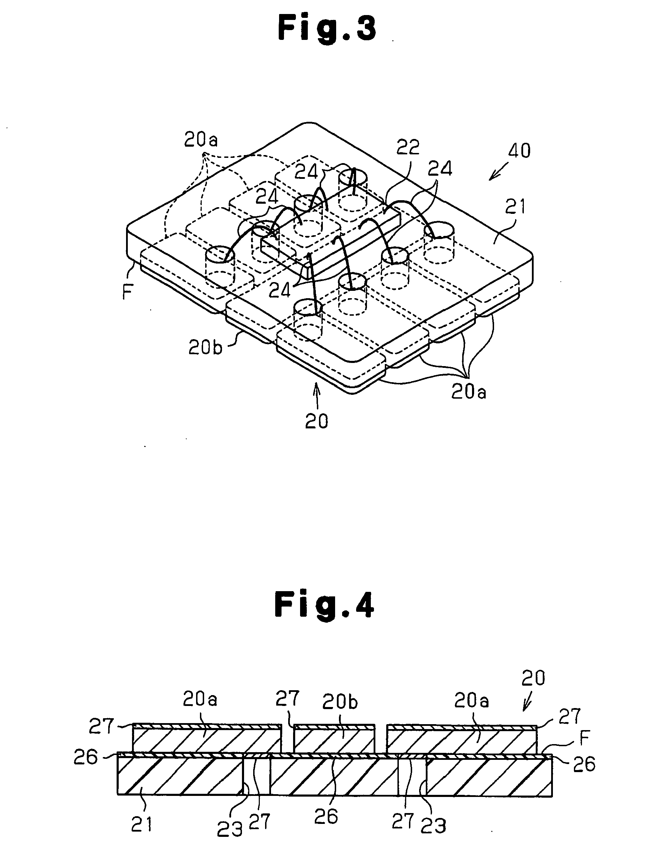

Referring to Figs. 2A, 2B and 3, the module 40 includes a substrate 21 (printed wiring board), which is made of an insulative material, and a pad group 20, which is arranged on a front surface (first surface) F of the substrate 21. The pad group 20 includes a plurality of contact pads 20a and 20b (nine in the preferred embodiment) for contacting terminals of an IC card reader (not shown). The contact pad 20b located in the middle functions as a ground terminal.

An IC chip 22, which functions as an electronic component, is arranged on the surface of the substrate 21 opposite the first surface F (rear surface). The substrate 21 has a thickness of, for example, 50 µm and is made of polyethylene terephthalate (PET). Further, the substrate 21 includes a plurality of wire bonding holes 23 (non-plated through holes). Lead lines 24 extend through the wire bonding holes 23 to electrically connect the contact pads 20a and the IC chip 22. The IC chip 22 and the lead lines 24 are covered by an encapsulation resin 25, which is, for example, an epoxy resin.

Referring to Fig. 4, an adhesive layer 26, which is made of an ultraviolet ray curing adhesive, is applied to the first surface F of the substrate 21. The contact pads 20a and 20b are bonded to the substrate 21 with the adhesive layer 26. The contact pads 20a and 20b are formed from a copper conductive foil. The conductive foil undergoes a treatment for adding a corrosive resistance property and a wear resistance property to the surface of the conductive foil. More specifically, a plating layer 27 is formed to add corrosive and wear resistance properties to the surfaces of the contact pads 20a and 20b (at portions for contacting the terminals of an IC card reader and portions exposed in the wire bonding holes 23). The plating layer 27 is made of, for example, nickel and formed by performing electroless plating. As used herein, electroless "nickel" plating refers to nickel-phosphor (Ni-P) alloy plating.

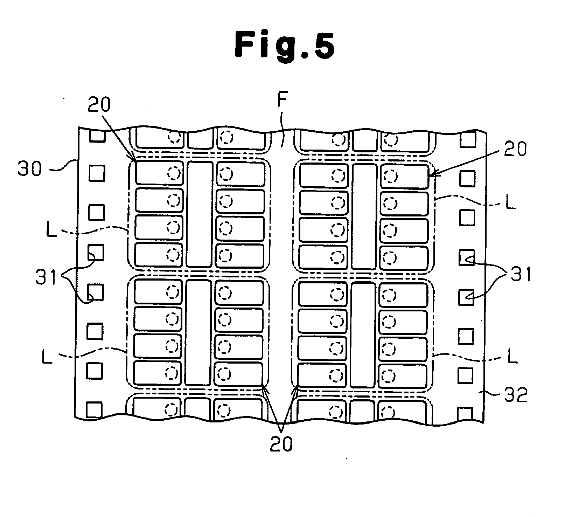

Referring to Fig. 5, the module 40 is formed by punching a tape carrier 30. The tape carrier 30 includes a strip-shaped substrate 32 (printed wiring board), which is made of an insulative material. A plurality of pad groups 20 are formed on the front surface (first surface) F of the substrate 32. The pad groups 20 are arranged in two rows in the longitudinal direction of the substrate 32. The substrate 32 of the tape carrier 30 corresponds to the substrate 21 of the module 40. The substrate 32 includes a plurality of wire bonding holes 23 in correspondence with each pad group 20.

Sprocket holes 31 are formed in the two sides of the substrate 32 along the longitudinal direction of the substrate 32. Sprockets of a feeder (not shown) are rotated in a state engaged with the sprocket holes 31 to move the tape carrier 30 in the longitudinal direction and transfer the pad groups 20 of the tape carrier 30.

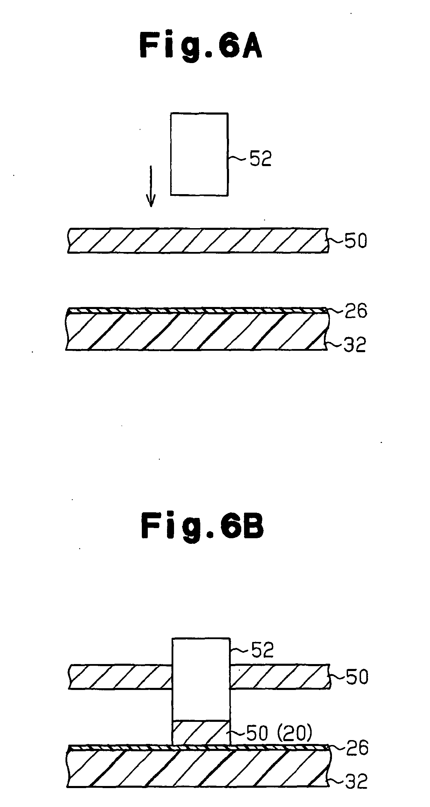

The formation of the pad groups 20 on the substrate 32 of the tape carrier 30 will now be described. The adhesive layer 26 is first applied to the front surface of the substrate 32. Then, the wire bonding holes 23 and the sprocket holes 31 are formed in the substrate 32, which includes the adhesive layer 26. Next, an elongated tape of a copper conductive foil 50 is arranged facing the substrate 32, as shown in the state of Fig. 6A. A punch 52 (punching tool) is arranged on the side of the substrate 32 opposite the conductive foil 50. The punch 52 includes a punching die patterned in correspondence with the pad groups 20. Feed-winding devices (not shown) hold the two ends of the conductive foil 50 to feed the conductive foil 50 in the longitudinal direction. While the conductive foil 50 and the substrate 32 are moved in synchronism, the punch 52 punches the conductive foil 50 and presses the punched out portions of the conductive foil 50 against the adhesive layer 26. One or more punches 52 may be used. Further, the punching die of each punch 52 may be shape in correspondence with a single pad group 20 or in correspondence with a plurality of pad groups 20. Referring to Fig. 6B, the punch 52 consecutively punches the conductive foil 50 and presses the punched out portions against the adhesive layer 26. Then, the adhesive layer 26 is irradiated with ultraviolet rays and hardened. This fixes the punched out portions of the conductive foil 50, that is, the pad groups 20 on the substrate 32 with the adhesive layer 26. Subsequently, electroless plating is performed to form the plating layer 27 (nickel plating layer) on the surfaces of the contact pads 20a and 20b, which form the pad groups 20.

In Fig. 5, the double-dotted lines represent a punching line L (cutting line). Punching (cutting) is performed along the punching line L with the punch 52 to obtain the module 40 (refer to Fig. 4), which includes a pad group 20 formed on the substrate 21. Adjacent pad groups 20 are spaced such as to prevent the pad groups 20 from becoming defective due to, for example, damage inflicted during the punching. Subsequent to the punching, the IC chip 22 is mounted to the rear surface of the substrate 21, and the pad group 20 is connected to the IC chip 22 by the lead lines 24. This completes the module 40. The IC chip may be mounted prior to the punching of the substrate 32.

The preferred embodiment has the advantages described below.

The punch 52 punches the conductive foil 50 to obtain the pad groups 20 and presses the punched out portions of the conductive foil 50 against the adhesive layer 26. This arranges the pad groups 20 on the substrate. Accordingly, the processes, work, and cost for manufacturing a tape carrier for a contact type IC card are reduced in comparison to when performing complicated and expensive photolithography processes to form the pad groups 20 on the substrate 32.

The substrate 32 (substrate 21) is made of polyethylene terephthalate (PET). Polyethylene terephthalate is less expensive than glass epoxy, which is normally used as a substrate material. This lowers the cost of the tape carrier 30. Further, when using the polyethylene terephthalate substrate 32 (substrate 21), in comparison with when using a glass epoxy substrate, less dust is produced during punching and less wear occurs on the punch 52.

The thickness of a glass epoxy substrate is normally 100 µm. However, the thickness of the polyethylene terephthalate substrate 32 (substrate 21) may be reduced to 50 µm or less, that is, one half or less of that of a glass epoxy substrate. This enables the thickness of the substrate 32 (substrate 21) to be reduced. Thus, the substrate 32 (substrate 21), which can be reduced in thickness, is suitable for use in an IC card of which thickness is limited. The thickness of the substrate 32 (substrate 21) may be selected from a range of 50 µm or less, for example, 50 µm or 25 µm, in accordance with the purpose of use.

The contact pads 20a and 20b are bonded to the substrate 32 (substrate 21) with the adhesive layer 26, which is made of an ultraviolet ray curing adhesive. The polyethylene terephthalate substrate 32 (substrate 21) is susceptible to heat. Thus, the use of an ultraviolet ray curing adhesive instead of a heat curing adhesive is advantageous for performing bonding in a preferable manner.

The plating layer 27 is applied to the surfaces of the contact pads 20a and 20b. In addition to improving the corrosion and wear resistance, this ensures satisfactory conduction between the contact pads 20a and 20b and the terminals of an IC card reader. Further, the bonding of the lead lines 24 to the contact pads 20a and 20b is performed in a preferable manner.

It should be apparent to those skilled in the art that the present invention may be embodied in many other specific forms without departing from the spirit or scope of the invention. Particularly, it should be understood that the present invention may be embodied in the following forms.

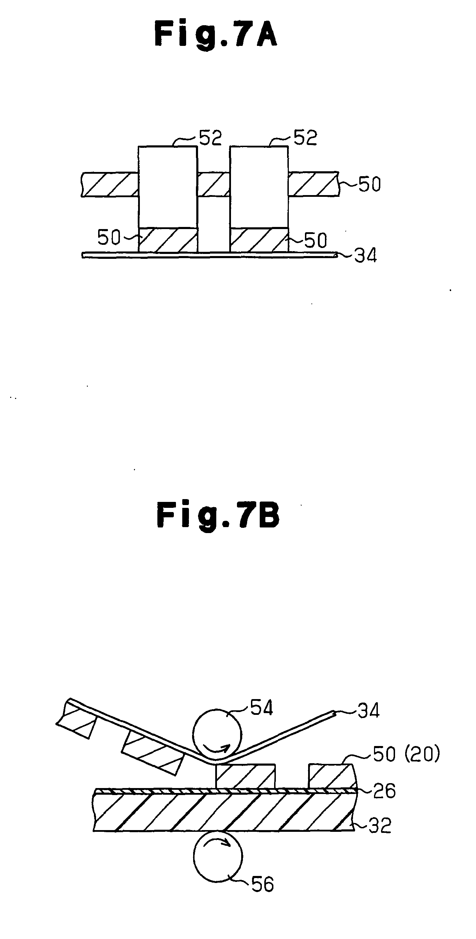

Instead of arranging the conductive foil 50 directly on the adhesive layer 26 as shown in Figs. 6A and 6B, the punch 52 may punch the conductive foil 50 onto another tape carrier 34, which functions as a transfer medium, as shown in Fig. 7A. The punched out portions of the conductive foil 50, or the pad groups 20, are adhered to the tape carrier 34 with an adhesive, which is applied to the surface of the tape carrier 34 beforehand. Then, referring to Fig. 7B, while the tape carrier 34 and the substrate 32 are being conveyed in the longitudinal direction, two rollers 54 and 56 press the pad groups 20 on the tape carrier 34 against the substrate 32. This consecutively transfers the pad groups 20 on the tape carrier 34 to the adhesive layer 26, which is applied to the substrate 32 beforehand. In this example, the pad groups 20 may be arranged on the substrate 32 at a predetermined timing after punching is performed by the punch 52. Since the pad groups 20 are transferred from the tape carrier 34 to the substrate 32, the adhesive force of the adhesive on the tape carrier 34 is not as strong as that of the adhesive layer 26 on the substrate 32.

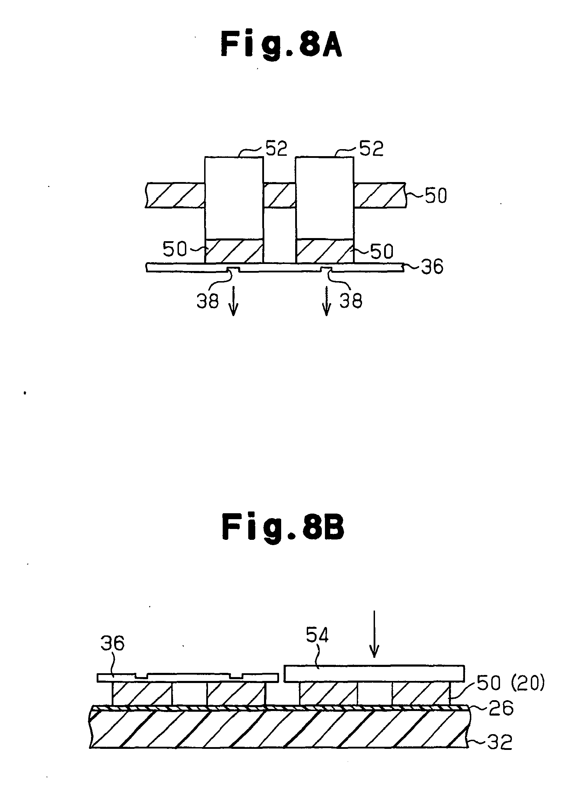

Alternatively, the punch 52 may punch the conductive foil 50 onto a suction pad 36, which functions as a transfer medium, as shown in Fig. 8A. The suction pad 36 is arranged on, for example, a robotic hand (not shown) of a transportation apparatus. The suction pad 36 includes air holes 38 connected to an aspiration apparatus. The aspiration apparatus produces an aspiration effect with the air holes 38 to attract the punched out portions of the conductive foil 50 onto the suction pad 36. Then, the pad groups 20 attracted onto the suction pad 36 are transported to a predetermined position located above the adhesive layer 26, as shown in the state of Fig. 8B. A pressing machine 54 may be used to press the pad groups 20 against the adhesive layer 26.

In Figs. 6A and 6B, in a state in which the tape of the conductive foil 50 faces toward the tape of the substrate 32 while the conductive foil 50 and the substrate 32 are moving, the conductive foil 50 is consecutively punched. Instead, in a state in which a sheet of the conductive foil 50 faces toward a sheet of the substrate 32, the conductive foil 50 may be punched once to form a large number of pad groups 20 at the same time. A tape carrier, as referred to in this specification, does not have to be a tape and may be a sheet.

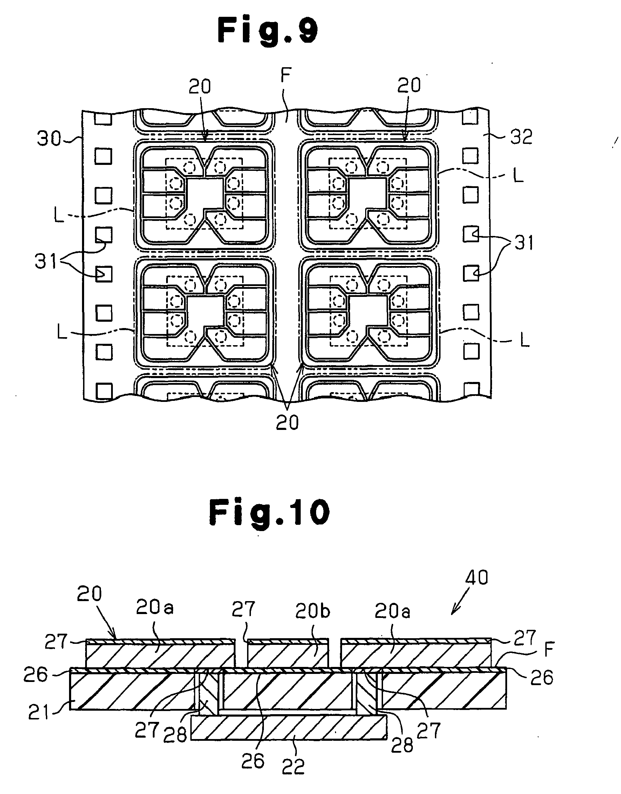

The contact pads 20a and 20b of the pad group 20 do not have to be patterned in the manner shown in Fig. 5 and may be patterned in any manner, for example, as shown in Fig. 9.

The arrangement of the pad groups 20 on the tape carrier 30 is not limited to the manner shown in Fig. 5 and may be changed in any manner. For example, in Fig. 5, the orientation of the pad groups 20 relative to the tape carrier 30 may be changed by 90 degrees. Further, in Fig. 5, the pad groups 20 are formed in two rows in the longitudinal direction of the tape carrier 30. However, as long as there is at least one row, the pad groups 20 may be arranged in any number of rows. For example, the pad groups 20 may be arranged in a single row or three or more rows in the longitudinal direction of the tape carrier 30.

The mounting of the IC chip 22 to the substrate 32 (substrate 21) is not limited to the manner shown in Fig. 3 and may be changed as required. For example, referring to Fig. 10, a flip-chip mount technology may be used to mount the IC chip 22. More specifically, as shown in Fig. 10, the IC chip 22 may be arranged on the side of the substrate 32 (substrate 21) opposite to the first surface F, which includes the pad group 20. The IC chip 22 is connected to the contact pads 20a by bumps 28, which extend through the substrate 32 (substrate 21). The bumps 28 are formed through, for example, soldering. In the structure shown in Fig. 10, the bonding holes 23 function as through holes, through which the bumps 28 extend.

The plating layer 27, which is formed through electroless plating, is not limited to monolayer of nickel. Any metal that is suitable for enabling bonding of the lead lines 24 may be used. For example, at least one element or alloy selected from nickel (i.e., nickel-phosphor alloy), gold, silver, palladium, and pure nickel may be used alone or in combination as a monolayer or a laminate. Preferably, the plating layer 27 includes a monolayer of nickel (i.e., nickel-phosphor alloy), a laminate of a nickel layer and an overlying gold layer, a laminate of a nickel layer and an overlying silver layer, and a laminate of a nickel layer and an overlying palladium.

In the preferred embodiment, subsequent to the formation of the contact pads 20a and 20b on the substrate 32, the plating layer 27 is formed on one side of the contact pads 20a and 20b. However, for example, electroless plating may be performed to form a nickel plating layer 27 on the two sides of a conductive foil. Then, the conductive foil may be used to form the contact pads 20a and 20b on the substrate 32.

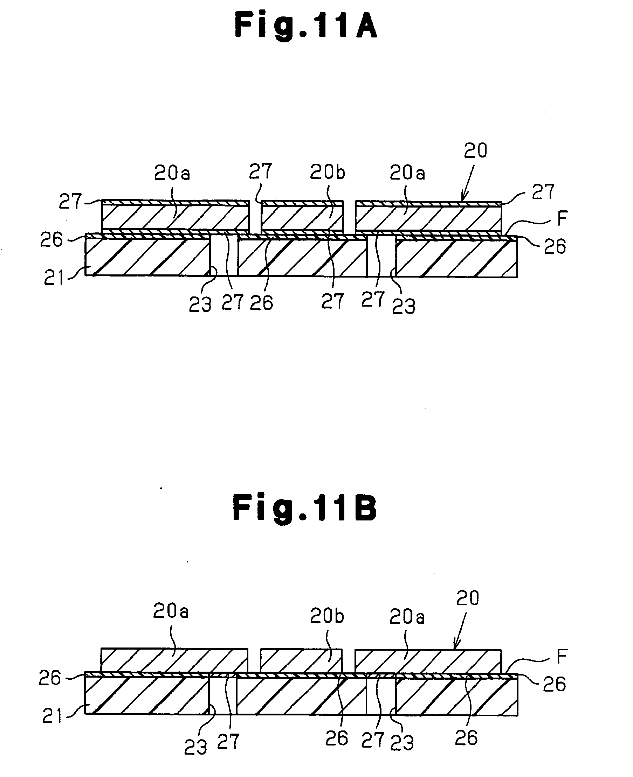

Referring to Fig. 11B, a conductive foil made of stainless steel may be used as the material for the contact pads 20a and 20b. A conductive foil of stainless steel has superior corrosion and wear resistance properties. Thus, the plating layer 27 needs to be formed only on the contact pads 20a, which undergo wire bonding.

In the preferred embodiment, the substrate 32 (substrate 21) is made of polyethylene terephthalate, the adhesive layer 26 is made of an ultraviolet ray curing adhesive, and the contact pads 20a and 20b are made of an copper conductive foil. However, for example, the substrate 32 (substrate 21) may be made of glass epoxy, the adhesive layer 26 may be made of a heat curing adhesive, and the contact pads 20a and 20b may be made of an aluminum or nickel conductive foil. The combination of these materials may be determined in any manner in accordance with the purpose of use from the viewpoint of reliability, cost, recyclability, and the like.

## Claims

1. A method for manufacturing a tape carrier for a contact type IC card, the method being **characterized by**:
punching a conductive foil with a punching tool to obtain a pad group including a plurality of contact pads; and
arranging the pad group on a substrate made of an insulative material.

2. The method according to claim 1, **characterized in that**:
the conductive foil is arranged facing toward the substrate; and
the punching tool directly presses the pad group obtained by punching the conductive foil against the substrate.

3. The method according to claim 1, further **characterized by**:
punching the conductive foil onto a transfer medium and arranging the pad group on the transfer medium; and
transferring the pad group from the transfer medium onto the substrate.

4. The method according to claim 3, **characterized in that** the transfer medium is a tape carrier or a suction pad.

5. The method according to claim 2, **characterized in that** the substrate and the conductive foil are tape-shaped and moved in synchronism during the punching.

6. The method according to any one of claims 1 to 5, further **characterized by**:
applying an adhesive layer to the substrate; and
adhering the pad group to the substrate with the adhesive layer.

7. The method according to claim 6, **characterized in that** the adhesive layer includes an ultraviolet ray curing adhesive.

8. The method according to any one of claims 1 to 7, **characterized in that** the substrate is made of polyethylene terephthalate or glass epoxy resin.

9. The method according to any one of claims 1 to 8, further **characterized by**:
forming a plating layer on a surface of the pad group by performing electroless plating.

10. The method according to claim 9, **characterized in that** the plating layer includes a monolayer or a laminate that is made of at least one element or alloy selected from nickel-phosphor alloy, gold, silver, palladium, and pure nickel.

11. The method according to any one of claim 1 to 10, **characterized in that** the conductive foil is made of a material selected from copper, aluminum, stainless, and nickel.

12. A contact type IC card pad module manufactured by cutting a contact type IC card tape carrier obtained through the method according to any one of claims 1 to 11.

## Amended claims

### Amended claims in accordance with Rule 137(2) EPC.

**1.** A method for manufacturing a tape carrier (30) for a contact type IC card, the method comprising
punching a conductive foil (50) with a punching tool (52) having a punching die patterned in correspondence with a pad group (20) including a plurality of contact pads (20a, 20b) to obtain the pad group (20) including a plurality of contact pads (20a, 20b), and
arranging the pad group (20) on a substrate (32) of the tape carrier (30), the substrate (32) being made of an insulative material.

**2.** The method according to claim 1, **characterized in that:**
the conductive foil (50) is arranged facing toward the substrate (32); and
the punching tool (52) directly presses the pad group (20) obtained by punching the conductive foil (50) against the substrate (32).

**3.** The method according to claim 1, further **characterized by**:
punching the conductive foil (50) onto a transfer medium (34) and arranging the pad group (20) on the transfer medium (34); and
transferring the pad group (20) from the transfer medium (34) onto the substrate (32).

**4.** The method according to claim 3, **characterized in that** the transfer medium is a tape carrier (34) or a suction pad (36).

**5.** The method according to claim 2, **characterized in that** the substrate (32) and the conductive foil (50) are tape-shaped and moved in synchronism during the punching.

**6.** The method according to any one of claims 1 to 5, further **characterized by**:
applying an adhesive layer (26) to the substrate (32); and
adhering the pad group (20) to the substrate (32) with the adhesive layer (26).

**7.** The method according to claim 6, **characterized in that** the adhesive layer (26) includes an ultraviolet ray curing adhesive.

**8.** The method according to any one of claims 1 to 7, **characterized in that** the substrate (32) is made of polyethylene terephthalate or glass epoxy resin.

**9.** The method according to any one of claims 1 to 8, further **characterized by**:
forming a plating layer (27) on a surface of the pad group (20) by performing electroless plating.

**10.** The method according to claim 9, **characterized in that** the plating layer (27) includes a monolayer or a laminate that is made of at least one element or alloy selected from nickel-phosphor alloy, gold, silver, palladium, and pure nickel.

**11.** The method according to any one of claims 1 to 10, **characterized in that** the conductive foil (50) is made of a material selected from copper, aluminium, stainless and nickel.

**12.** A contact type IC card pad module manufactured by cutting a contact type IC card type carrier, obtained through the method according to any one of claims 1 to 11.
